(19) Europäisches Patentamt
European Patent Office
Office européen des brevets

(11) **EP 3 442 118 A1**

(12) **EUROPEAN PATENT APPLICATION**
published in accordance with Art. 153(4) EPC

(43) Date of publication:
**13.02.2019 Bulletin 2019/07**

(51) Int Cl.:
***H03B 5/12*** *(2006.01)*

(21) Application number: **16910965.9**

(86) International application number:
**PCT/CN2016/092838**

(22) Date of filing: **02.08.2016**

(87) International publication number:
**WO 2018/023367 (08.02.2018 Gazette 2018/06)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(71) Applicant: **Huawei Technologies Co., Ltd.**
**Longgang District**
**Shenzhen, Guangdong 518129 (CN)**

(72) Inventors:
• **LUO, Xun**
 **Chengdu**
 **Sichuan 610054 (CN)**
• **QIAN, Huizhen**
 **Chengdu**
 **Sichuan 610054 (CN)**

(74) Representative: **Maiwald Patent- und**
 **Rechtsanwaltsgesellschaft mbH**
 **Elisenhof**
 **Elisenstraße 3**
 **80335 München (DE)**

(54) **VOLTAGE WAVEFORM SHAPING OSCILLATOR**

(57)     The present invention provides a voltage waveform shaping oscillator, including a signal source and a coupling transformer. An output end of the signal source is connected to an input end of the coupling transformer, and an input end of the signal source is connected to an output end of the coupling transformer. The signal source is configured to: receive, by using the input end of the signal source, a quasi-square wave signal output by the output end of the coupling transformer, generate an original signal based on the quasi-square wave signal, and send the original signal to the input end of the coupling transformer by using the output end of the signal source, where the original signal is an oscillating signal, and the output end of the signal source is an output end of the oscillator and is configured to output the original signal. The coupling transformer is configured to: receive the original signal by using the input end of the coupling transformer, perform filtering processing on the original signal to obtain the quasi-square wave signal, and send the quasi-square wave signal to the input end of the signal source by using the output end of the coupling transformer. The voltage waveform shaping oscillator is configured to reduce phase noise of an oscillator.

EP 3 442 118 A1

FIG. 1

**Description**

**TECHNICAL FIELD**

Embodiments of the present invention relate to the field of electronic technologies, and in particular, to a voltage waveform shaping oscillator.

**BACKGROUND**

Oscillators are core devices for generating frequency sources in transceiver systems. Therefore, oscillators need to be used in most integrated circuits and systems.

Phase noise is a main performance indicator of an oscillator, and a value of the phase noise directly affects working performance of the oscillator, thereby affecting sensitivity of a transceiver system. In the prior art, a frequency multiplier circuit is usually added to an oscillator to reduce phase noise of the oscillator. However, after the frequency multiplier circuit is added to the oscillator, total power consumption of the oscillator becomes excessively high.

**SUMMARY**

Embodiments of the present invention provide a voltage waveform shaping oscillator, so as to reduce phase noise of an oscillator.

According to a first aspect, an embodiment of the present invention provides a voltage waveform shaping oscillator, including a signal source and a coupling transformer, where an output end of the signal source is connected to an input end of the coupling transformer, and an input end of the signal source is connected to an output end of the coupling transformer, where

the signal source is configured to: receive, by using the input end of the signal source, a quasi-square wave signal output by the output end of the coupling transformer, generate an original signal based on the quasi-square wave signal, and send the original signal to the input end of the coupling transformer by using the output end of the signal source, where the original signal is an oscillating signal, and the output end of the signal source is an output end of the oscillator and is configured to output the original signal; and

the coupling transformer is configured to: receive the original signal by using the input end of the coupling transformer, perform filtering processing on the original signal to obtain the quasi-square wave signal, and send the quasi-square wave signal to the input end of the signal source by using the output end of the coupling transformer.

After performing filtering on the original signal, the coupling transformer may generate the quasi-square wave signal having relatively low phase noise, and the frequency multiplier circuit does not need to be added to the oscillator, thereby reducing phase noise of the oscillator without increasing total power consumption of the oscillator.

Optionally, the original signal may include a multiple-frequency signal generated by the signal source.

In a possible implementation, the coupling transformer includes a first transformer, where the first transformer is configured to perform filtering processing on the original signal to obtain the quasi-square wave signal, where the quasi-square wave signal includes a fundamental frequency signal and at least one $N^{th}$ harmonic signal, and N is an odd number greater than 1.

In another possible implementation, the first transformer includes a first resonator and a second resonator coupled to each other, where

an input end of the first resonator is connected to the output end of the signal source; and

an output end of the second resonator is connected to the input end of the signal source.

Optionally, when a coupling factor between the first resonator and the second resonator is a preset coupling factor, correspondingly, the quasi-square wave signal includes the fundamental frequency signal and an $M^{th}$ harmonic signal corresponding to the preset coupling factor in the at least one $N^{th}$ harmonic signal, where M is an odd number greater than 1.

In another possible implementation, the coupling transformer further includes a second transformer and a third transformer, where

the second transformer includes the first resonator and a third resonator coupled to each other;

the third transformer includes the second resonator and the third resonator coupled to each other; and

the second transformer and the third transformer are configured to perform adjustment processing on a frequency of the quasi-square wave signal.

Optionally, a coupling factor between the third resonator and the first resonator is less than the preset coupling factor; and a coupling factor between the third resonator and the second resonator is less than the preset coupling factor.

The coupling factor between the third resonator and the first resonator is less than the preset coupling factor, and the coupling factor between the third resonator and the second resonator is less than the preset coupling factor, so that the second transformer and the third transformer can perform more precise adjustment on the frequency of the quasi-square wave signal.

In another possible implementation, the first resonator includes a first inductor and a first capacitor array connected to each other;

the second resonator includes a second inductor and a second capacitor array connected to each other; and

the third resonator includes a third inductor and a third capacitor array connected to each other, and the third capacitor array includes at least one of a variable capacitor or a switched capacitor array, where

in the first transformer, the first resonator and the second resonator are coupled to each other by using the first inductor and the second inductor;

in the second transformer, the first resonator and the third resonator are coupled to each other by using the first inductor and the third inductor; and

in the third transformer, the second resonator and the third resonator are coupled to each other by using the second inductor and the third inductor.

Optionally, the first capacitor array and/or the second capacitor array include/includes at least one of the variable capacitor or the switched capacitor array. The first inductor and/or the second inductor include/includes at least one of a variable inductor or a switched inductor array.

In another possible implementation, the signal source includes a transistor configured to generate the original signal based on the quasi-square wave signal.

In another possible implementation, the transistor is a metal oxide semiconductor (Metal Oxide Semiconductor, MOS for short) transistor, where

a source of the MOS transistor is electrically connected to the first power supply;

a gate of the MOS transistor is electrically connected to the output end of the second resonator; and

a drain of the MOS transistor is electrically connected to the input end of the first resonator.

Optionally, the gate of the MOS transistor is coupled to a second power supply by using the output end of the second resonator, and a difference between a voltage of the second power supply and a voltage of the first power supply is greater than a threshold voltage of the MOS transistor.

Optionally, the drain of the MOS transistor is coupled to a third power supply by using the input end of the first resonator, and the third power supply is a constant power supply.

In another possible implementation, the first power supply includes a transistor and a resistor connected in series.

Optionally, the first capacitor array and/or a second capacitor array are/is configured to perform adjustment processing on the frequency of the quasi-square wave signal based on a first resolution. The third capacitor array is configured to perform adjustment processing on the frequency of the quasi-square wave signal based on a second resolution.

Optionally, the first resolution is greater than the second resolution, so that the frequency of the quasi-square wave signal is roughly adjusted by using the first capacitor array and/or the second capacitor array, and the frequency of the quasi-square wave signal is finely adjusted by using the third capacitor array.

Optionally, the first capacitor array includes a first variable capacitor group and a second variable capacitor group. The first resolution may include a third resolution and a fourth resolution. The third resolution and the fourth resolution are different and respectively correspond to the first variable capacitor group and the second variable capacitor group. The third resolution and the fourth resolution are both greater than the second resolution. Each variable capacitor group may include a variable capacitor or a switched capacitor array. Therefore, three different variable capacitors are provided in the embodiments of the present invention to implement rough adjustment, intermediate adjustment, and fine adjustment, thereby improving flexibility of frequency adjustment of an oscillator.

The voltage waveform shaping oscillator provided in the embodiments of the present invention includes a signal source and a coupling transformer. An output end of the signal source is connected to an input end of the coupling transformer, and an input end of the signal source is connected to an output end of the coupling transformer. The signal source is configured to: receive, by using the input end of the signal source, a quasi-square wave signal output by the output end of the coupling transformer, generate an original signal based on the quasi-square wave signal, and send the original signal to the input end of the coupling transformer by using the output end of the signal source. The coupling transformer is configured to: receive the original signal by using the input end of the coupling transformer, perform filtering processing on the original signal to obtain the quasi-square wave signal, and send the quasi-square wave signal to the input end of the signal source by using the output end of the coupling transformer. In the foregoing process, after performing filtering on an original signal, a coupling transformer may generate a quasi-square wave signal having relatively low phase noise, and a frequency multiplier circuit does not need to be added to an oscillator, thereby reducing phase noise of the oscillator without increasing total power consumption of the oscillator.

**BRIEF DESCRIPTION OF DRAWINGS**

FIG. 1 is a schematic structural diagram 1 of a voltage waveform shaping oscillator according to an embodiment of the present invention;

FIG. 2 is a schematic structural diagram 2 of a voltage waveform shaping oscillator according to an embodiment of the present invention;

FIG. 3 is a schematic waveform diagram of a quasi-square wave signal according to an embodiment of the present invention;

FIG. 4 is a schematic structural diagram 3 of a voltage waveform shaping oscillator according to an embodiment of the present invention;

FIG. 5 is a schematic structural diagram 4 of a voltage waveform shaping oscillator according to an embodiment of the present invention;

FIG. 6 is an equivalent circuit diagram of a coupling transformer according to an embodiment of the present invention;

FIG. 7 is a schematic spectrum diagram 1 of a quasi-square wave signal according to an embodiment of the present invention; and

FIG. 8 is a schematic spectrum diagram 2 of a quasi-square wave signal according to an embodiment of the present invention.

**DESCRIPTION OF EMBODIMENTS**

To make the objectives, technical solutions, and advantages of the embodiments of the present invention clearer, the following clearly and completely describes the technical solutions in the embodiments of the present invention with reference to the accompanying drawings in the embodiments of the present invention. Apparently, the described embodiments are some but not all of the embodiments of the present invention. All other embodiments obtained by a person of ordinary skill in the art based on the embodiments of the present invention without creative efforts shall fall within the protection scope of the present invention.

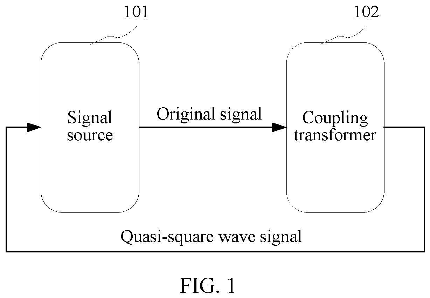

FIG. 1 is a schematic structural diagram 1 of a voltage waveform shaping oscillator according to an embodiment of the present invention. Referring to FIG. 1, the voltage waveform shaping oscillator (oscillator for short hereinafter) includes a signal source 101 and a coupling transformer 102. An output end of the signal source 101 is connected to an input end of the coupling transformer 102. An input end of the signal source 101 is connected to an output end of the coupling transformer 102.

The signal source 101 is configured to: receive, by using the input end of the signal source 101, a quasi-square wave signal output by the output end of the coupling transformer 102, generate an original signal based on the quasi-square wave signal, and send the original signal to the input end of the coupling transformer 102 by using the output end of the signal source 101. The original signal is an oscillating signal, and the output end of the signal source 101 is an output end of the oscillator and is configured to output the original signal.

The coupling transformer 102 is configured to: receive the original signal by using the input end of the coupling transformer 102, perform filtering processing on the original signal to obtain the quasi-square wave signal, and send the quasi-square wave signal to the input end of the signal source 101 by using the output end of the coupling transformer 102.

In the embodiment shown in FIG. 1, the output end of the signal source 101 is connected to the input end of the coupling transformer 102, and the output end of the coupling transformer 102 is connected to the input end of the signal source 101, so that the signal source 101 and the coupling transformer 102 form a processing loop, and cyclic processing is performed on a signal.

A process in which the oscillator is initially powered on till the oscillator works stably is described below. In a first working process (or working period) after the oscillator is started, the signal source 101 generates a multiple-frequency signal, and sends the multiple-frequency signal to the input end of the coupling transformer 102 by using the output end of the signal source 101. In the first working process, an original signal includes the multiple-frequency signal. The coupling transformer 102 performs filtering processing on the received multiple-frequency signal to obtain a quasi-square wave signal, and sends the quasi-square wave signal to the input end of the signal source 101 by using the output end of the coupling transformer 102.

In an $X^{th}$ (X is a positive integer greater than 1) working process (or working period) after the oscillator is started, the signal source 101 receives, by using the input end, the quasi-square wave signal output by the output end of the coupling transformer 102, and performs amplification processing on the quasi-square wave signal. The signal source 101 further generates a multiple-frequency signal and performs superimposing processing on the quasi-square wave signal on which the amplification processing has been performed and the multiple-frequency signal to obtain the original signal. The signal source 101 sends the original signal to the input end of the coupling transformer 102 by using the output end. The coupling transformer 102 performs processing on the received original signal to obtain a quasi-square wave signal, and sends the quasi-square wave signal to the input end of the signal source 101 by using the output end of the coupling transformer 102.

It should be noted that within a preset time period after the oscillator is started, working of the oscillator is unstable, resulting in that the coupling transformer 102 outputs different quasi-square wave signals in different working processes. After the preset time period, the working of the oscillator becomes stable, so that the quasi-square wave signals output by the coupling transformer 102 no longer change radically.

In this embodiment of the present invention, the quasi-square wave signal is named as a quasi-square wave signal because the quasi-square wave signal has a shape similar to that of a square wave. A square wave is obtained by means of ideal filtering. The quasi-square wave signal in this embodiment is a signal approximate to a square wave.

Optionally, the coupling transformer in this embodiment of the present invention may be implemented by using a single layer of metal or multiple layers of metal.

The voltage waveform shaping oscillator provided in this embodiment of the present invention includes a signal source and a coupling transformer. An output end of the signal source is connected to an input end of the coupling transformer, and an input end of the signal source is connected to an output end of the coupling transformer. The signal source is configured to: receive, by using the input end of the signal source, a quasi-square wave signal output by the output end of the coupling transformer, generate an original signal based on the quasi-square wave signal, and send the original signal to the input end of the coupling transformer by using the output end of the signal source. The coupling transformer is configured to: receive the original signal by using the input end of the coupling transformer, perform filtering processing on the original signal to obtain the quasi-square wave signal, and send the quasi-square wave signal to the input end of the signal source by using the output end of the coupling transformer. In the foregoing process, after performing filtering on an original signal, a coupling transformer may generate a quasi-square wave signal having relatively low phase noise, and a frequency multiplier circuit does not need to be added to an oscillator, thereby reducing phase noise of the oscillator without increasing total power consumption of the oscillator.

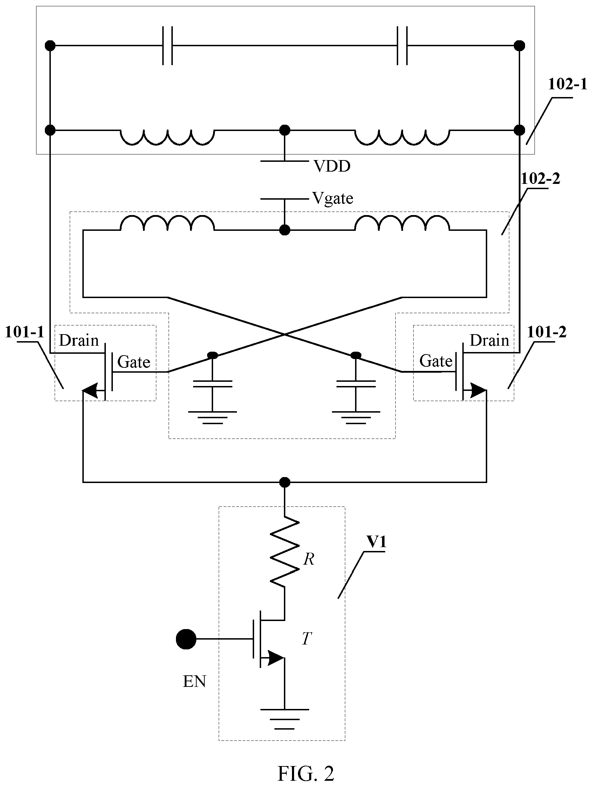

Based on the embodiment shown in FIG. 1, the coupling transformer may include a first transformer, and the first transformer performs filtering processing on an original signal to obtain a quasi-square wave signal. Optionally, the coupling transformer may include multiple resonators. Further, the signal source may include one or two transistors. The transistor may be a MOS transistor, a diode, and the like. A structure of an oscillator is described below in detail in the embodiment shown in FIG. 2 by using an example in which the first transformer includes a first resonator and a second resonator and the signal source includes two MOS transistors.

FIG. 2 is a schematic structural diagram 2 of a voltage waveform shaping oscillator according to an embodiment of the present invention. Referring to FIG. 2, a signal source 101 includes a first MOS transistor 101-1 and a second MOS transistor 101-2. A coupling transformer 102 includes a first resonator 102-1 and a second resonator 102-2 coupled to each other. The first resonator 102-1 and the second resonator 102-2 that are coupled to each other form a first transformer.

Sources of the first MOS transistor 101-1 and the second MOS transistor 101-2 are electrically connected to a first power supply (having a voltage value VI).

Gates of the first MOS transistor 101-1 and the second MOS transistor 101-2 are electrically connected to an output end of the second resonator 102-2. The gates of the first MOS transistor 101-1 and the second MOS transistor 101-2 are coupled to a second power supply (having a voltage value Vgate) by using the output end of the second resonator 102-2. A difference between a voltage of the second power supply and a voltage of the first power supply is greater than a threshold voltage of the first MOS transistor 101-1 and the second MOS transistor 101-2.

Drains of the first MOS transistor 101-1 and the second MOS transistor 101-2 are electrically connected to an input end of the first resonator 102-1. The drains of the first MOS transistor 101-1 and the second MOS transistor 101-2 are coupled to a third power supply by using the input end of the first resonator 102-1. The third power supply may be a constant power supply (having a voltage value VDD).

In the embodiment shown in FIG. 2, the first transformer includes the first resonator 102-1 and the second resonator 102-2. Optionally, the first resonator 102-1 and the second resonator 102-2 may include capacitors and inductors disposed in series or in parallel. A coupling factor between the first resonator 102-1 and the second resonator 102-2 is a preset coupling factor. A quasi-square wave signal obtained by the first transformer through processing includes a fundamental frequency signal of the oscillator and an $M^{th}$ harmonic signal corresponding to the preset coupling factor, and M is an odd number greater than 1.

During actual application, when the first resonator 102-1 and the second resonator 102-2 have different coupling factors, different orders M of the harmonic signal are obtained after the first transformer performs processing. For example, the quasi-square wave signal may include the fundamental frequency signal and a third harmonic signal, and the quasi-square wave signal may include the fundamental frequency signal and a fifth harmonic signal. During actual application, the coupling factor between the first resonator 102-1 and the second resonator 102-2 may be set according to an actual requirement and this embodiment of the present invention is not specifically limited thereto.

It should be noted that the first transformer may further include multiple resonators (more than two). When the first transformer includes multiple resonators, the quasi-square wave signals obtained by the first transformer through processing include the fundamental frequency signal of the oscillator and multiple Nth harmonic signals, where N is an odd number greater than 1. The Mth harmonic signal described above is one of the multiple Nth harmonic signals. For example, the quasi-square wave signal may include the fundamental frequency signal, a third harmonic signal, a fifth harmonic signal, and the like. During actual application, a quantity of resonators included in the first transformer may be set according to an actual requirement. This is not specifically limited in the present invention.

In FIG. 2, optionally, the first power supply may include a transistor T and a resistor R connected in series. The transistor may be a MOS transistor, a diode, and the like. A voltage V1 generated by the first power supply may be generated by the transistor T. Specifically, when the transistor T is a MOS transistor, a gate of the MOS transistor is controlled by using an enable signal EN, a source may be grounded, and a drain may be coupled to the resistor R or another impedor so as to generate the voltage V1.

A working process of the oscillator described in the embodiment of FIG. 2 is described in detail below.

After the first MOS transistor 101-1 and the second MOS transistor 101-2 are powered on, differences between voltages (Vgate) of gates of the first MOS transistor 101-1 and the second MOS transistor 101-2 and a voltage (V1) of the first power supply are greater than a threshold voltage of the first MOS transistor 101-1 and the second MOS transistor 101-2. Therefore, after the first MOS transistor 101-1 and the second MOS transistor 101-2 are powered on, the gates of the first MOS transistor 101-1 and the second MOS transistor 101-2 are turned on.

After the first MOS transistor 101-1 and the second MOS transistor 101-2 are powered on, the first MOS transistor 101-1 and the second MOS transistor 101-2 generate a multiple-frequency signal. Optionally, the multiple-frequency signal may be represented by formula 1:

$$f(t) = A_1 \sin(\Omega t) + A_2 \sin(2\Omega t) + A_3 \sin(3\Omega t) + \ldots\ldots + A_n \sin(n\Omega t) \quad \text{formula 1,}$$

where $\Omega = 2\pi f$, $f$ is a frequency, $A_n$ is an amplitude, and t represents time, $f(t)$ is the multiple-frequency signal, where the multiple-frequency signal is a combination of multiple signals.

The first MOS transistor 101-1 and the second MOS transistor 101-2 send, by using the drains, the generated multiple-frequency signal to the first transformer that includes the first resonator 102-1 and the second resonator 102-2. The first transformer performs filtering processing on the received multiple-frequency signal to obtain a fundamental frequency signal and an Mth harmonic that corresponds to a coupling factor between the first resonator 102-1 and the second resonator 102-2. Assuming that the coupling factor between the first resonator 102-1 and the second resonator 102-2 corresponds to a third harmonic, after the first transformer processes the multiple-frequency signal, the fundamental frequency signal and a third harmonic signal are obtained. The fundamental frequency signal and the third harmonic signal form a quasi-square wave signal. A frequency of the fundamental frequency signal is related to a capacitor and an inductor in the first resonator 102-1 and the second resonator 102-2.

After obtaining the quasi-square wave signal, the first transformer sends the quasi-square wave signal to the gates of the first MOS transistor 101-1 and the second MOS transistor 101-2. The first MOS transistor 101-1 and the second MOS transistor 101-2 perform amplification processing on the received quasi-square wave signal. The first MOS transistor 101-1 and the second MOS transistor 101-2 further generate a multiple-frequency signal, and perform superimposing processing on the multiple-frequency signal and the quasi-square wave signal on which the amplification processing has been performed, to obtain an original signal. The first MOS transistor 101-1 and the second MOS transistor 101-2 send the original signal to the first transformer by using the drains. The first transformer performs filtering processing on the received original signal to obtain a new quasi-square wave signal and sends the quasi-square wave signal to the first MOS transistor 101-1 and the second MOS transistor 101-2 by using a gate. The foregoing process is repeated, and the quasi-square wave signal is continuously amplified until the oscillator reaches a stable state. After the oscillator reaches a stable state, the quasi-square wave signal generated by the oscillator does not change any longer. Because phase noise of the quasi-square wave signal is relatively low, phase noise of the oscillator is further reduced.

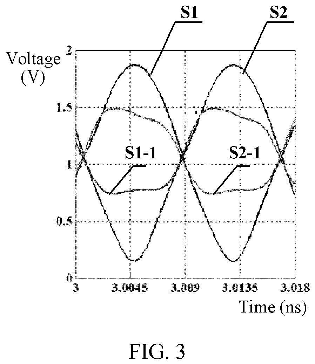

Based on the embodiment shown in FIG. 2, a waveform of the quasi-square wave signal is described in detail with reference to FIG. 3.

FIG. 3 is a schematic waveform diagram of a quasi-square wave signal according to an embodiment of the present invention. Referring to FIG. 3, a sinusoidal signal waveform S1, a sinusoidal signal waveform S2, a quasi-square wave signal waveform S1-1, and a quasi-square wave signal waveform S2-1 are included.

The sinusoidal signal waveform S1 is a waveform of a multiple-frequency signal generated by the first MOS transistor 101-1. The sinusoidal signal waveform S2 is a waveform of a multiple-frequency signal generated by the second MOS transistor 101-2. The quasi-square wave signal waveform S1-1 is a waveform of a quasi-square wave signal obtained by the first MOS transistor 101-1 and the coupling transformer 102 through processing. The a quasi-square wave signal waveform S2-1 is a waveform of a quasi-square wave signal obtained by the second MOS transistor 101-2 and the coupling transformer 102 through processing.

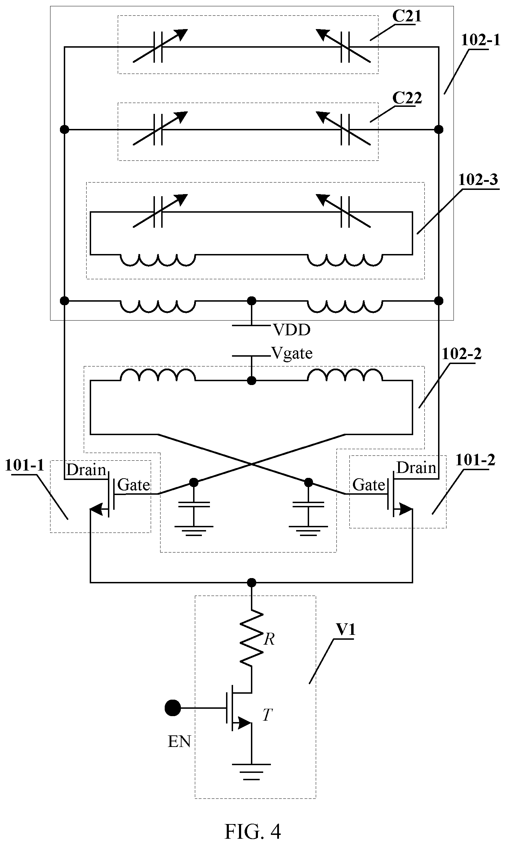

Based on the embodiments shown in FIG. 2 and FIG. 3, to achieve variability of a frequency of the quasi-square wave signal, a capacitor and/or an inductor in the first resonator 102-1 and/or the second resonator 102-2 may be set to be variable. The capacitor may be a switched capacitor array. A person skilled in the art may understand that the switched capacitor array may include multiple switches and multiple capacitors. The switches and capacitors are connected in series or in parallel in a particular form. A capacitance value of the switched capacitor array is adjusted by controlling a switch to be opened or closed, so as to achieve variability of a capacitor. The inductor may be a switched inductor array. An inductance value is adjusted by controlling a switch to be opened or closed, so as to achieve variability of an inductor. Further, the coupling transformer 102 may further include a second transformer and a third transformer and precisely adjusts the frequency of the quasi-square wave signal by using the second transformer and the third transformer. Specifically, refer to the embodiment shown in FIG. 4.

FIG. 4 is a schematic structural diagram 3 of a voltage waveform shaping oscillator according to an embodiment of the present invention. Referring to FIG. 4, a coupling transformer further includes a second transformer that includes a first resonator 102-1 and a third resonator 102-3 coupled to each other and a third transformer that includes a second resonator 102-2 and the third resonator 102-3 coupled to each other. The second transformer and the third transformer are configured to adjust a frequency of a quasi-square wave signal.

In the first transformer, the first resonator 102-1 and the second resonator 102-2 are coupled to each other by using a first inductor and a second inductor. In the second transformer, the first resonator 102-1 and the third resonator 102-3 are coupled to each other by using the first inductor and a third inductor. In the third transformer, the second resonator 102-2 and the third resonator 102-3 are coupled to each other by using the second inductor and the third inductor.

The first resonator 102-1 includes the first inductor and a first capacitor array connected to each other. The second resonator 102-2 includes the second inductor and a second capacitor array connected to each other. The third resonator 102-3 includes the third inductor and a third capacitor array connected to each other, and the third capacitor array includes at least one of a variable capacitor or a switched capacitor array.

During actual application, optionally, the first capacitor array and/or the second capacitor array may include at least one of the variable capacitor or the switched capacitor array. The first capacitor array and/or a second capacitor array are/is configured to perform adjustment processing on the frequency of the quasi-square wave signal based on a first resolution. The third capacitor array is configured to perform adjustment processing on the frequency of the quasi-square wave signal based on a second resolution. Optionally, the first resolution is greater than the second resolution. In this way, the frequency of the quasi-square wave signal may be roughly adjusted by using the first capacitor array and/or the second capacitor array, and the frequency of the quasi-square wave signal may be finely adjusted by using the third capacitor array.

Optionally, when a capacitor array includes a variable capacitor, adjustment of a capacitance value may be implemented by changing a physical parameter of the capacitor. When a capacitor array includes a switched capacitor array, adjustment of a capacitance value may be implemented by controlling a status (an opened state and a closed state) of a switch.

In the embodiment shown in FIG. 4, the first capacitor array in the first resonator 102-1 includes a first variable capacitor group C21 and a second variable capacitor group C22. Either of the first variable capacitor group C21 and the second variable capacitor group C22 may be a switched capacitor array, so that a capacitance value is adjusted by controlling opening or closing of a switch. A capacitor included in the second resonator 102-2 is a nonvariable capacitor. The third resonator 102-3 includes a variable capacitor.

During actual application, to facilitate adjustment of the frequency of the quasi-square wave signal, optionally, capacitance values of the first variable capacitor group C21 and the second variable capacitor group C22 may be set to different values, so that rough adjustment and intermediate adjustment are performed on the frequency of the quasi-square wave signal by using the first variable capacitor group C21 and the second variable capacitor group C22 respectively. Therefore, resolutions of adjusting the frequency of the quasi-square wave signal by the first variable capacitor group C21 and the second variable capacitor group C22 may be different. Therefore, the first resolution that can be adjusted by the first capacitor array may include a third resolution and a fourth resolution, and the third resolution and the fourth resolution are different but are both greater than the second resolution. Fine adjustment is performed on the frequency of the quasi-square wave signal by using a variable capacitor in the third resonator 102-3. Optionally, to enable the second transformer and the third transformer to perform more precise adjustment on the frequency of the quasi-square wave signal, a coupling factor between the third resonator 102-3 and the first resonator 102-1 is less than a coupling factor between the first resonator 102-1 and the second resonator 102-2; and a coupling factor between the third resonator 102-3 and the second resonator 102-2 is less than a coupling factor between the first resonator 102-1 and the second resonator 102-2.

It should be noted that the circuit diagram shown in FIG. 3 merely shows capacitor and inductor devices in each resonator in the coupling transformer 102 in a form of an example, but is not used to limit the capacitor and inductor devices in each resonator in the coupling transformer 102. During actual application, the capacitor and inductor devices in each resonator may further be set according to an actual requirement. For example, the first capacitor array may include multiple variable capacitors, but the second capacitor array does not include any variable capacitor. Alternatively, the first capacitor array does not include any variable capacitor, but the second capacitor array includes multiple variable capacitors. Alternatively, both the first capacitor array and the second capacitor array include a variable capacitor. Further, the first inductor and/or the second inductor may include at least one of a variable inductor or a switched inductor array.

In the foregoing process, the first resonator 102-1 to the third resonator 102-3 may include the variable capacitor and/or the variable inductor, so that the variable capacitor and/or the variable inductor in the first resonator 102-1 to the third resonator may be adjusted, thereby implementing adjustment of the frequency of the quasi-square wave signal.

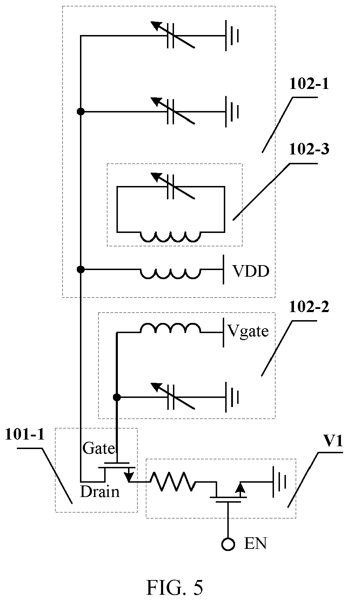

During actual application, there may further be one MOS transistor in a signal source. Based on the embodiment shown in FIG. 4, a structure of an oscillator in which the signal source includes one MOS transistor is described below in detail with reference to an embodiment shown in FIG. 5.

FIG. 5 is a schematic structural diagram 4 of a voltage waveform shaping oscillator according to an embodiment of the present invention. Referring to FIG. 5, the oscillator includes one MOS transistor 101-1, and a coupling transformer 102 includes a first resonator 102-1, a second resonator 102-2, and a third resonator 102-3. The first resonator 102-1 and the second resonator 102-2 form a first transformer. The first resonator 102-1 and the third resonator 102-3 form a second transformer. The second resonator 102-2 and the third resonator 102-3 form a third transformer.

In the embodiment shown in FIG. 5, optionally, the first resonator 102-1, the second resonator 102-2, and the third resonator 102-3 all include a variable capacitor. It should be noted that FIG. 5 shows a structure of an oscillator that includes one MOS transistor only in a form of an example, but does not specifically limit capacitor and inductor devices included in each resonator. The working process of the oscillator described in the embodiment of FIG. 5 is similar to the working process of the oscillator described in the embodiment of FIG. 4, and details are not repeatedly described herein.

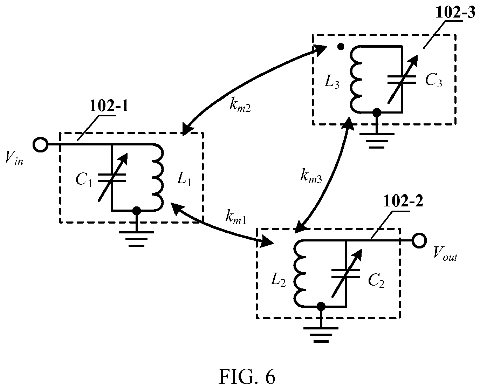

Based on the embodiment shown in FIG. 4 or FIG. 5, the coupling transformer 102 shown in the embodiment shown in FIG. 4 or FIG. 5 is described in detail by means of an equivalent circuit diagram of a coupling transformer 102 shown in FIG. 6.

FIG. 6 is an equivalent circuit diagram of a coupling transformer 102 according to an embodiment of the present invention. Referring to FIG. 6, a first resonator 102-1, a second resonator 102-2, and a third resonator 102-3 are included.

The first resonator 102-1 and the second resonator 102-2 form a first transformer. The first resonator 102-1 and the third resonator 102-3 form a second transformer. The second resonator 102-2 and the third resonator 102-3 form a third transformer.

In the coupling transformer 102 shown in FIG. 6, $k_{m1}$ is a coupling factor of the first transformer, $k_{m2}$ is a coupling factor of the second transformer, and $k_{m3}$ is a coupling factor of the third transformer. During actual application, a harmonic order (harmonic frequency) of a quasi-square wave signal may be determined by setting $k_{m1}$, $k_{m2}$, and $k_{m3}$. Specifically, the harmonic frequency of the quasi-square wave signal may be roughly adjusted by adjusting $k_{m1}$, and the harmonic frequency of the quasi-square wave signal may be finely adjusted by adjusting $k_{m2}$ and $k_{m3}$.

In example 1, it is assumed that relationships between capacitance and inductance of resonators in the coupling transformer 102 are as follows:

$$\frac{L_2}{L_1} = 3, \quad \frac{L_2}{L_3} = 4, \quad \frac{C_2}{C_1} = 1, \quad \frac{C_2}{C_3} = 25, \quad k_{m2} = 0.2, \text{ and } k_{m3} = 0.1.$$

$L_1$ is an inductance value of the first resonator 102-1, and $C_1$ is a capacitance value of the first resonator 102-1. $L_2$ is an inductance value of the second resonator 102-2, and $C_2$ is a capacitance value of the second resonator 102-2. $L_3$ is an inductance value of the third resonator 102-3, and $C_3$ is a capacitance value of the third resonator 102-3.

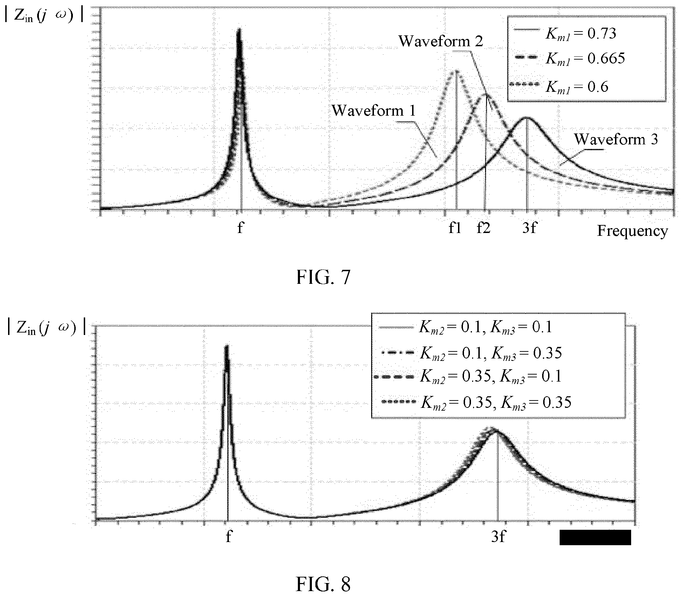

When $k_{m1}$ has different values, the quasi-square wave signal has different harmonic orders. Specifically, refer to a frequency diagram shown in FIG. 7.

FIG. 7 is a schematic spectrum diagram 1 of a quasi-square wave signal according to an embodiment of the present invention. Referring to FIG. 7, a frequency of a fundamental frequency signal in the quasi-square wave signal is f.

When $k_{m1}$ = 0.6, a waveform of the quasi-square wave signal is a waveform 1, and a harmonic frequency of the quasi-square wave signal is f1.

When $k_{m1}$ = 0.665, a waveform of the quasi-square wave signal is a waveform 2, and a harmonic frequency of the quasi-square wave signal is f2.

When $k_{m1}$ = 0.73, a waveform of the quasi-square wave signal is a waveform 3, and a harmonic frequency of the quasi-square wave signal is f3.

It may be known from above that by adjusting $k_{m1}$, a harmonic frequency of a harmonic signal in the quasi-square wave signal may be roughly adjusted. When $k_{m1} = 0.73$, the harmonic signal in the quasi-square wave signal is a third harmonic signal. Therefore, $k_{m1}$ may be set to 0.73.

In example 2, it is assumed that relationships between capacitance and inductance of resonators in the coupling transformer 102 are as follows:

$$\frac{L_2}{L_1} = 3 \ , \quad \frac{L_2}{L_3} = 4 \ , \quad \frac{C_2}{C_1} = 1 \ , \quad \frac{C_2}{C_3} = 25 \ , \text{ and } \quad k_{m1} = 0.73 \ .$$

When $k_{m2}$ and $k_{m3}$ have different values, the quasi-square wave signal has different harmonic orders (harmonic frequency). Specifically, refer to the frequency diagram shown in FIG. 7.

FIG. 8 is a schematic spectrum diagram 2 of a quasi-square wave signal according to an embodiment of the present invention. Referring to FIG. 8, a frequency of a fundamental frequency signal in the quasi-square wave signal is f.

When $k_{m2} = 0.35$ and $k_{m3} = 0.35$, or when $k_{m2} = 0.35$ and $k_{m3} = 0.1$, or when $k_{m2} = 0.1$ and $k_{m3} = 0.35$, harmonic frequencies of the quasi-square wave signals are close to 3f. However, none of the harmonic frequencies of the quasi-square wave signals equals 3f.

When $k_{m2} = 0.1$ and $k_{m3} = 0.1$, the harmonic frequencies of the quasi-square wave signals equal 3f.

It may be known from above that by adjusting $k_{m2}$ and $k_{m3}$, a harmonic frequency of a harmonic signal in a quasi-square wave signal may be finely adjusted. When $k_{m2} = 0.1$ and $k_{m3} = 0.1$, the harmonic signal in the quasi-square wave signal is a third harmonic signal. Therefore, both $k_{m2}$ and $k_{m3}$ may be set to 0.1.

It should be noted that some of the components in the oscillator shown in the foregoing embodiments may be combined/divided, and a single fully quadrature oscillator, an array differential oscillator, a fully quadrature array oscillator, a single frequency source, an array frequency source, a single transceiver system, and an array transceiver system may further be implemented. This is not repeatedly described in this embodiment of the present invention.

Finally, it should be noted that the foregoing embodiments are merely intended for describing the technical solutions of the present invention, but not for limiting the present invention. Although the present invention is described in detail with reference to the foregoing embodiments, persons of ordinary skill in the art should understand that they may still make modifications to the technical solutions described in the foregoing embodiments or make equivalent replacements to some or all technical features thereof, without departing from the scope of the technical solutions of the embodiments of the present invention.

## Claims

1. A voltage waveform shaping oscillator, comprising a signal source and a coupling transformer, wherein an output end of the signal source is connected to an input end of the coupling transformer, and an input end of the signal source is connected to an output end of the coupling transformer, wherein

   the signal source is configured to: receive, by using the input end of the signal source, a quasi-square wave signal output by the output end of the coupling transformer, generate an original signal based on the quasi-square wave signal, and send the original signal to the input end of the coupling transformer by using the output end of the signal source, wherein the original signal is an oscillating signal, and the output end of the signal source is an output end of the oscillator and is configured to output the original signal; and

   the coupling transformer is configured to: receive the original signal by using the input end of the coupling transformer, perform filtering processing on the original signal to obtain the quasi-square wave signal, and send the quasi-square wave signal to the input end of the signal source by using the output end of the coupling transformer.

2. The oscillator according to claim 1, wherein

   the original signal comprises a multiple-frequency signal generated by the signal source and the quasi-square wave signal.

3. The oscillator according to claim 1 or 2, wherein the coupling transformer comprises a first transformer, wherein

   the first transformer is configured to perform filtering processing on the original signal to obtain the quasi-square wave signal, wherein the quasi-square wave signal comprises a fundamental frequency signal and at least one $N^{th}$ harmonic signal, and N is an odd number greater than 1.

4. The oscillator according to claim 3, wherein the first transformer comprises a first resonator and a second resonator coupled to each other, wherein
an input end of the first resonator is connected to the output end of the signal source; and
an output end of the second resonator is connected to the input end of the signal source.

5. The oscillator according to claim 4, wherein a coupling factor between the first resonator and the second resonator is a preset coupling factor; and
correspondingly, the quasi-square wave signal comprises the fundamental frequency signal and an $M^{th}$ harmonic signal corresponding to the preset coupling factor in the at least one $N^{th}$ harmonic signal, wherein M is an odd number greater than 1.

6. The oscillator according to claim 4 or 5, wherein the coupling transformer further comprises a second transformer and a third transformer, wherein
the second transformer comprises the first resonator and a third resonator coupled to each other;
the third transformer comprises the second resonator and the third resonator coupled to each other; and
the second transformer and the third transformer are configured to perform adjustment processing on a frequency of the quasi-square wave signal.

7. The oscillator according to claim 6, wherein
a coupling factor between the third resonator and the first resonator is less than the preset coupling factor; and
a coupling factor between the third resonator and the second resonator is less than the preset coupling factor.

8. The oscillator according to claim 6 or 7, wherein
the first resonator comprises a first inductor and a first capacitor array connected to each other;
the second resonator comprises a second inductor and a second capacitor array connected to each other; and
the third resonator comprises a third inductor and a third capacitor array connected to each other, and the third capacitor array comprises at least one of a variable capacitor or a switched capacitor array, wherein
in the first transformer, the first resonator and the second resonator are coupled to each other by using the first inductor and the second inductor;
in the second transformer, the first resonator and the third resonator are coupled to each other by using the first inductor and the third inductor; and
in the third transformer, the second resonator and the third resonator are coupled to each other by using the second inductor and the third inductor.

9. The oscillator according to claim 8, wherein the first capacitor array and/or the second capacitor array comprise/comprises at least one of the variable capacitor or the switched capacitor array.

10. The oscillator according to claim 8 or 9, wherein the first inductor and/or the second inductor comprise/comprises at least one of a variable inductor or a switched inductor array.

11. The oscillator according to any one of claims 8 to 10, wherein the signal source comprises a transistor configured to generate the original signal based on the quasi-square wave signal.

12. The oscillator according to claim 11, wherein the transistor is a metal oxide semiconductor MOS transistor, wherein
a source of the MOS transistor is electrically connected to the first power supply;
a gate of the MOS transistor is electrically connected to the output end of the second resonator; and
a drain of the MOS transistor is electrically connected to the input end of the first resonator.

13. The oscillator according to claim 12, wherein the gate of the MOS transistor is coupled to a second power supply by using the output end of the second resonator, and a difference between a voltage of the second power supply and a voltage of the first power supply is greater than a threshold voltage of the MOS transistor.

14. The oscillator according to claim 12 or 13, wherein the drain of the MOS transistor is coupled to a third power supply by using the input end of the first resonator, and the third power supply is a constant power supply.

15. The oscillator according to any one of claims 12 to 14, wherein the first power supply comprises a transistor and a resistor connected in series.

**16.** The oscillator according to any one of claims 8 to 15, wherein the first capacitor array and/or a second capacitor array are/is configured to perform adjustment processing on the frequency of the quasi-square wave signal based on a first resolution.

**17.** The oscillator according to claim 16, wherein the third capacitor array is configured to perform adjustment processing on the frequency of the quasi-square wave signal based on a second resolution.

**18.** The oscillator according to claim 17, wherein the first resolution is greater than the second resolution.

FIG. 1

FIG. 2

FIG. 3

FIG. 4

FIG. 5

FIG. 6

$| Z_{in}(j\ \omega)\ |$

Waveform 2

Waveform 1

Waveform 3

$K_{m1} = 0.73$
$K_{m1} = 0.665$
$K_{m1} = 0.6$

f          f1  f2   3f          Frequency

FIG. 7

$| Z_{in}(j\ \omega)\ |$

$K_{m2} = 0.1, K_{m3} = 0.1$
$K_{m2} = 0.1, K_{m3} = 0.35$
$K_{m2} = 0.35, K_{m3} = 0.1$
$K_{m2} = 0.35, K_{m3} = 0.35$

f                              3f

FIG. 8

## INTERNATIONAL SEARCH REPORT

International application No.

PCT/CN2016/092838

### A. CLASSIFICATION OF SUBJECT MATTER

H03B 5/12 (2006.01) i

According to International Patent Classification (IPC) or to both national classification and IPC

### B. FIELDS SEARCHED

Minimum documentation searched (classification system followed by classification symbols)

H03B

Documentation searched other than minimum documentation to the extent that such documents are included in the fields searched

Electronic data base consulted during the international search (name of data base and, where practicable, search terms used)

CNPAT, WPI, EPODOC, CNKI: 耦合,? 方波, 振荡, 变压器, 电压, 振荡器, 滤波耦合, 滤波, transformer?, coupl +, filter+

### C. DOCUMENTS CONSIDERED TO BE RELEVANT

| Category* | Citation of document, with indication, where appropriate, of the relevant passages | Relevant to claim No. |
|---|---|---|
| X | CN 104272583 A (HUAWEI TECHNOLOGIES CO., LTD.), 07 January 2015 (07.01.2015), description, paragraphs [0002]-[0167], and figures 1-7 | 1-11, 16-18 |
| Y | CN 104272583 A (HUAWEI TECHNOLOGIES CO., LTD.), 07 January 2015 (07.01.2015), description, paragraphs [0002]-[0167], and figures 1-7 | 12-15 |
| Y | US 2016056762 A1 (XIMENES, A.R. et al.), 25 February 2016 (25.02.2016), description, paragraphs [0037]-[0051], and figure 2A | 12-15 |
| X | CN 105187013 A (INTEL CORPORATION), 23 December 2015 (23.12.2015), description, paragraphs [0009]-[0019], and figures 1A-1B | 1-5 |
| A | CN 103138692 A (INTEL MOBILE COMMUNICATIONS GMBH), 05 June 2013 (05.06.2013), entire document | 1-18 |

☐ Further documents are listed in the continuation of Box C.      ☒ See patent family annex.

| | |
|---|---|
| *    Special categories of cited documents: | "T"   later document published after the international filing date or priority date and not in conflict with the application but cited to understand the principle or theory underlying the invention |
| "A"   document defining the general state of the art which is not considered to be of particular relevance | |
| "E"   earlier application or patent but published on or after the international filing date | "X"   document of particular relevance; the claimed invention cannot be considered novel or cannot be considered to involve an inventive step when the document is taken alone |
| "L"   document which may throw doubts on priority claim(s) or which is cited to establish the publication date of another citation or other special reason (as specified) | "Y"   document of particular relevance; the claimed invention cannot be considered to involve an inventive step when the document is combined with one or more other such documents, such combination being obvious to a person skilled in the art |
| "O"   document referring to an oral disclosure, use, exhibition or other means | |
| "P"   document published prior to the international filing date but later than the priority date claimed | "&"   document member of the same patent family |

| Date of the actual completion of the international search | Date of mailing of the international search report |
|---|---|
| 06 April 2017 | 02 May 2017 |

| Name and mailing address of the ISA / CN: | Authorized officer |
|---|---|
| State Intellectual Property Office of the P. R. China<br>No. 6, Xitucheng Road, Jimenqiao<br>Haidian District, Beijing 100088, China<br>Facsimile No.: (86-10) 62019451 | DUAN, Wenting<br><br>Telephone No.: (86-10) 62414456 |

Form PCT/ISA/210 (second sheet) (July 2009)

## INTERNATIONAL SEARCH REPORT
### Information on patent family members

| International application No. |
| --- |
| PCT/CN2016/092838 |

| Patent Documents referred in the Report | Publication Date | Patent Family | Publication Date |
| --- | --- | --- | --- |
| CN 104272583 A | 07 January 2015 | US 9337847 B2 | 10 May 2016 |
| | | US 2014320215 A1 | 30 October 2014 |
| | | WO 2014124690 A1 | 21 August 2014 |
| US 2016056762 A1 | 25 February 2016 | US 9401677 B2 | 26 July 2016 |
| | | WO 2016029000 A2 | 25 February 2016 |
| | | US 2016056799 A1 | 25 February 2016 |
| | | US 9374036 B2 | 21 June 2016 |
| | | WO 2016029000 A3 | 28 April 2016 |
| | | US 2016056827 A1 | 25 February 2016 |
| | | US 2016056825 A1 | 25 February 2016 |
| | | US 9455667 B2 | 27 September 2016 |
| | | WO 2016029058 A1 | 25 February 2016 |
| CN 105187013 A | 23 December 2015 | EP 2999112 A1 | 23 March 2016 |
| | | US 9093950 B2 | 28 July 2015 |
| | | EP 2795790 A1 | 29 October 2014 |
| | | US 2013309983 A1 | 21 November 2013 |
| | | US 9473068 B2 | 18 October 2016 |
| | | HK 1213371 A1 | 30 June 2016 |
| | | JP 2015503296 A | 29 January 2015 |
| | | CN 103988422 A | 13 August 2014 |
| | | WO 2013095328 A1 | 27 June 2013 |
| | | US 2015372643 A1 | 24 December 2015 |
| | | EP 2795790 A4 | 29 July 2015 |
| CN 103138692 A | 05 June 2013 | US 2013135057 A1 | 30 May 2013 |
| | | CN 103138692 B | 28 December 2016 |
| | | US 8773211 B2 | 08 July 2014 |

Form PCT/ISA/210 (patent family annex) (July 2009)